(19) Europäisches Patentamt European Patent Office Office européen des brevets

(11) EP 0 977 271 B1

(12) EUROPEAN PATENT SPECIFICATION

(45) Date of publication and mention of the grant of the patent:
02.04.2008 Bulletin 2008/14

(51) Int Cl.:
*H01L 29/739* (2006.01)    *H01L 27/06* (2006.01)

(21) Application number: 99305767.8

(22) Date of filing: 21.07.1999

(54) **Semiconductor IGBT module**

Halbleiter-IGBT-Modul

Module IGBT semi-conducteur

(84) Designated Contracting States:
DE FR GB

(30) Priority: 28.07.1998  JP 21226298

(43) Date of publication of application:
02.02.2000  Bulletin 2000/05

(73) Proprietor: Hitachi, Ltd.
Chiyoda-ku,
Tokyo (JP)

(72) Inventors:
• Nagasu, Masahiro
  Ibaraki 312-0061 (JP)
• Kobayashi, Hideo
  Ibaraki 319-1221 (JP)
• Sakano, Junichi
  Ibaraki 319-1225 (JP)
• Mori, Mutsuhiro
  Ibaraki 310-0842 (JP)

(74) Representative: Calderbank, Thomas Roger et al
Mewburn Ellis LLP
York House
23 Kingsway
London WC2B 6HP (GB)

(56) References cited:
EP-A- 0 423 721          EP-A- 0 492 558
EP-A- 0 840 379

• PATENT ABSTRACTS OF JAPAN vol. 1997, no. 09, 30 September 1997 (1997-09-30) & JP 09 121052 A (FUJI ELECTRIC CO LTD), 6 May 1997 (1997-05-06)
• PATENT ABSTRACTS OF JAPAN vol. 004, no. 071 (E-012), 24 May 1980 (1980-05-24) & JP 55 038058 A (TOSHIBA CORP), 17 March 1980 (1980-03-17)

## Description

The present invention relates to a semiconductor device (hereinafter, referred to as an "IGBT module") in which an insulated gate bipolar transistor and a diode are connected in inverse parallel.

Following development of power electronics, making an electric power converter such as an inverter highly efficient, low in noise and small in size is desired. An insulated gate bipolar transistor (hereinafter, referred to an "IGBT") serving this requirement is a voltage drive type device having both of high output like a bipolar transistor and high speed like a MOSFET. Therefore, the drive circuit can be reduced in size in comparison with the bipolar transistor, which is the current control type device.

The IGBT is usually used in the IGBT module form. The IGBT module is the semiconductor device in which the insulated gate bipolar transistor and the diode connected in inverse parallel are installed in one package and from which an electrode terminal is taken out, and the IGBT module is used mainly for the electric power converter such as the inverter.

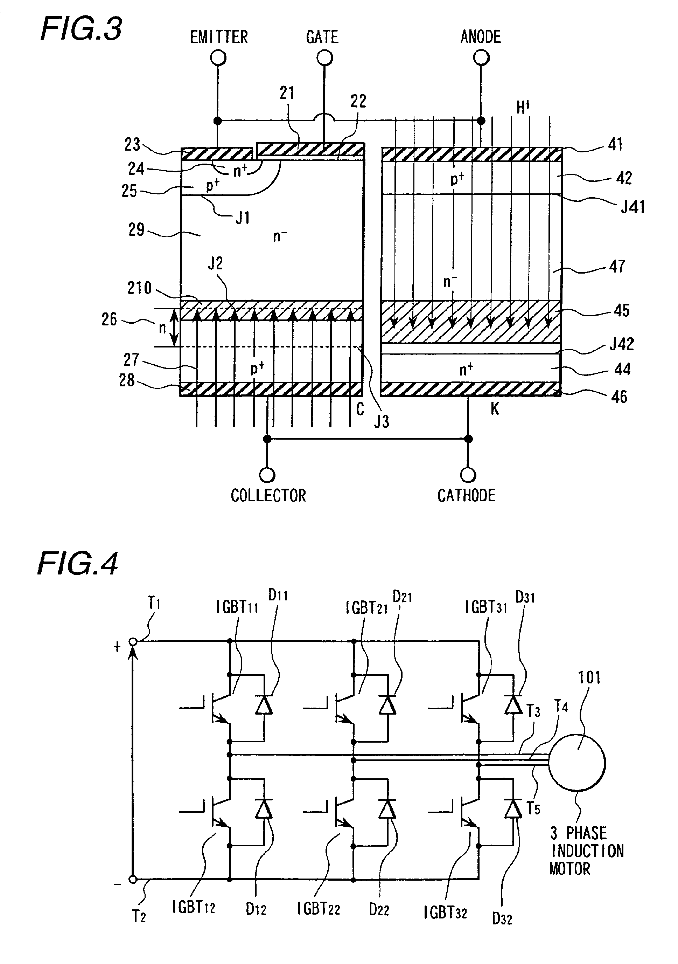

Fig. 4 is the inverter circuit applying the IGBT module. IGBT11-32, D11-32, and 101 show the IGBTs, diodes, and the three-phase induction motor, respectively. The terminals T1 and T2 are connected to a direct current power source. The IGBT module has various types such as one pair of the IGBT and the diode, upper and under arms of one phase, and upper and under arms of three phases, each installed in one package. These types are used properly in the applications.

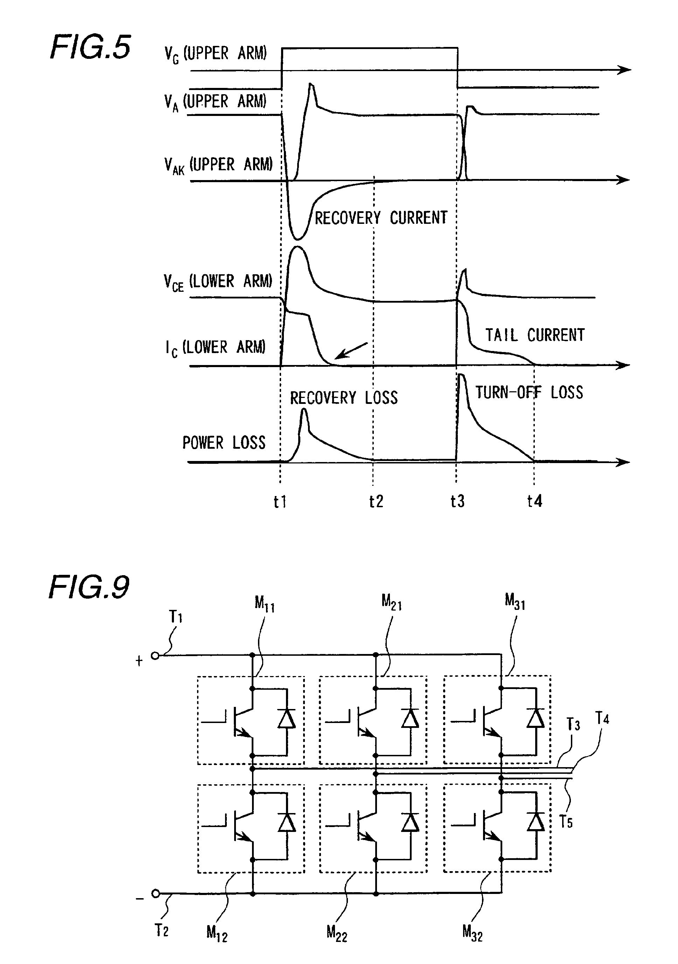

In Fig.4, an electric current flows via the IGBT11, the three-phase induction motor 101 and the IGBT22, with the IGBT11 and IGBT22 on. Then the current flows, with the three phases induction motor turning via the IGBT11, the three phases induction motor and the diode D21, with the IGBT22 off. The current flows through the diode D21 and IGBT22 with the IGBT22 on again. Fig. 5 shows the switching waveforms of the IGBT module at this time for the anode current IA and the voltage VAK between the anode and the cathode in the diode D21 of the upper arm in Fig. 4, and the collector current IC and the voltage VCE between the collector and the emitter of the IGBT22 of the under arm. When the IGBT22 is turned on, the electric current of the diode D21 is turned off, and when the IGBT22 is turned off, a current flows in diode D21 again.

Reducing a loss of the IGBT module is important to reduce a loss of the inverter circuit. Therefore, an improvement to reduce the switching loss and the on-voltage of the IGBT is advancing in recent years.

The IGBT has a low on-voltage with accumulating electrons and holes in the low impurity density semiconductor layer, which is usually n-type semiconductor layer(hereinafter referred to as a "n-base layer"), accomplishing a role for blocking a voltage applied to the device at a steady off-state. As the accumulation quantity of the electrons and holes is increased, the on-voltage becomes low. However, much turn-off electric power loss occurs with decreasing of the on-voltage because of the accumulated charge. Accordingly, the on-voltage of the IGBT is set so that the sum of the on-loss occuring at the steady on-state, the turn-off loss occuring at the turn-off time, and the turn-on loss occuring when changing from the off-state to the on-state is minimized, considering an operation frequency and a voltage of a power source etc, in applying the IGBT to a power converter.

The value of the on-voltage of the IGBT is controlled with adjusting the accumulation quantity of electrons and holes by the life time control in the n-base layer, and a conventional life time control was done by an electron- ray irradiation. An electron ray can easily pass through materials so that it perfectly passes through a semiconductor device having 300- 800 $\mu$m in total thickness. In the device, the electron ray makes a uniform crystal defect. Therefore, there is a problem that an on-voltage increases with a uniformly short life time in the n- base layer.

On the other hand, as Japanese patent Laid-open print No. 9-121052 states, the technique of shortening a life time locally by irradiation of light ions such as a helium and a proton(hereinafter referred to as a local life time control") is known for reducing turn-off time and turn-off loss without increasing on- voltage.

Additionally, in a diode, as Japanese patent Laid-open print No. 55-38058 states, the technique of local lifetime control shortens reverse recovery time and reduces loss when a current flowing changes from forward direction to reverse direction without increasing a leak current.

EP 0423721 discloses a semiconductor device comprising an IGBT and diode connected in inverse parallel. The diode includes a crystal defect layer to protect against overvoltage.

As stated above, the loss of an IGBT and that of a diode can be reduced individually by the local life time control.

In contrast, a present invention has an object to reduce the loss in a semiconductor device containing an IGBT and a diode.

The present invention has an another object to provide an electric power converter that has low electric power loss.

In order to meet the objects, the present invention discloses a semiconductor device according to claim 1, a method according to claim 8 and an electric power converter according to claim 9.

A semiconductor device according to the present invention has a parallel circuit in which an insulated gate bipolar transistor and a diode are connected in inverse parallel, and the device has a first voltage value and a second voltage larger than the first voltage value so that a leak current increases at the voltage values when a blocking voltage is applied to the parallel circuit.

The relationship between this leak current and the applied voltage is acquired by forming a local life time control region in each of semiconductor regions in the insulated gate bipolar transistor and the diode. When a depletion layer expanding to each of the semiconductor regions in the insulated gate bipolar transistor and the diode by the blocking voltage reaches the local life time control region, the leak electric current increases. As for desirability, the depletion layer in the insulated gate bipolar transistor reaches the local life time control region at the first voltage value, and the depletion layer in the diode reaches the local life time control region in the second voltage value.In the insulated gate bipolar transistor, the turn-off loss is reduced by the local lifetime control region with suppression of increasing of the on-voltage. In the diode, loss by a recovery current is reduced by the local lifetime control region with suppression of an occurrence of a noise at the recovery time. Therefore, electric power loss of the whole semiconductor device is reduced.

By connecting a semiconductor device according to the present invention to a direct current power source for supplying a direct current voltage and by driving the device with setting the direct current voltage between the first voltage value and the second voltage value, the electric power loss that occurs in the device is reduced.

When this semiconductor device is connected to the direct current power source that supplies the direct current voltage and the direct current voltage is set between the first voltage value and the second voltage value in the power converter that converts electric power by switching on and off the semiconductor device, the electric power loss of the power converter decreases because the electric power loss occuring in the device according to the present invention is reduced,.

The further concrete structure of a semiconductor device according to the present invention is the following. An insulated bipolar transistor has a first semiconductor region of a first conductivity type, a second semiconductor region of a second conductivity type ajacent to the first semiconductor region with a local life time control region, a third semiconductor region of the first conductivity type ajacent to the second semiconductor region, and a fourth semiconductor region of the second conductivity type provided in the third semiconductor region. A first main electrode low resitively (ohmicaly) contacts to the first semiconductor region. A second main electrode low resitively (ohmicaly) contacts to the third and forth semiconductor regions. On the surface of the third semiconductor region, an insulated gate is provided through an insulation film. A diode has a fifth semiconductor region of the second conductivity type with a local life time control region and a sixth semiconductor region of the first conductivity type ajacent to the fifth semiconductor region. A third main electrode low resistively contacts to the fifth semiconductor region, and a fourth main electrode low resistively contacts to the sixth semiconductor region. By electrically connecting the first main electrode and the third main electrode and electrically connecting the second main electrode and the fourth main electrode, the insulated gate bipolar transistor and the diode are connected in inverse parallel.

It is desirable that the second semiconductor region in the insulated gate bipolar transistor has a first part adjacent to the first semiconductor region and a second part which is adjacent to the first part and the third semiconductor region and of which impurity density is lower than the first part. It is desirable that the local life time control region in the second semiconductor region is located in a region extending over the first part, the first part containing the boundary of the second part and the second part. It is desirable that the fifth semiconductor region in the diode has a third part ajacent to the third main electrode and a fourth part which is ajacent to the third part and the sixth semiconductor region and of which impurity density is lower than the third part. It is desirable that the local life time control region in the fifth semiconductor region is located in the fourth part.

The above mentioned first and second conductivity types are p type or n type respectively, and they are opposite conductivity types with respect to each other. The first and second main electrodes correspond to a collector electrode and an emitter electrode of the insulated gate bipolar transistor respectively, and the third and fourth main electrodes correspond to a cathode electrode and an anode electrode of the transistor respectively. The above mentioned first and third parts correspond to a so-called buffer layer, and the second and fourth parts correspond to low concentrated base layers.

Other desirable structure of semiconductor devices having a parallel circuit of an insulated gate bipolar transistor and a diode such as the local life time control region will be clarify by the following explanations.

In the drawings:

Fig. 1 illustrates an IGBT module according to the present invention.
Fig. 2 shows reverse voltage characteristics of the IGBT module.
Fig. 3 shows a sectional view of an IGBT and a diode in the IGBT module. diode.
Fig. 4 shows an inverter circuit diagram using the IGBT module.
Fig. 5 shows switching waveforms of the IGBT module.
Fig. 6 shows relationship between the turnoff loss and recovery loss of the IGBT module and a half-value width of an injection ion kind distribution.
Fig. 7 shows relationship between the turnoff loss of the IGBT module and a ratio of the half-value width in an injected ion kind distribution and a thickness of the n⁻ layer.
Fig. 8 shows relationship between the recovery loss of the IGBT module and the ratio of the half-value width in the injected ion kind distribution and a thickness of the n⁻ layer.

Fig. 9 shows an example of a main circuit of a power inverter according to the present invention.

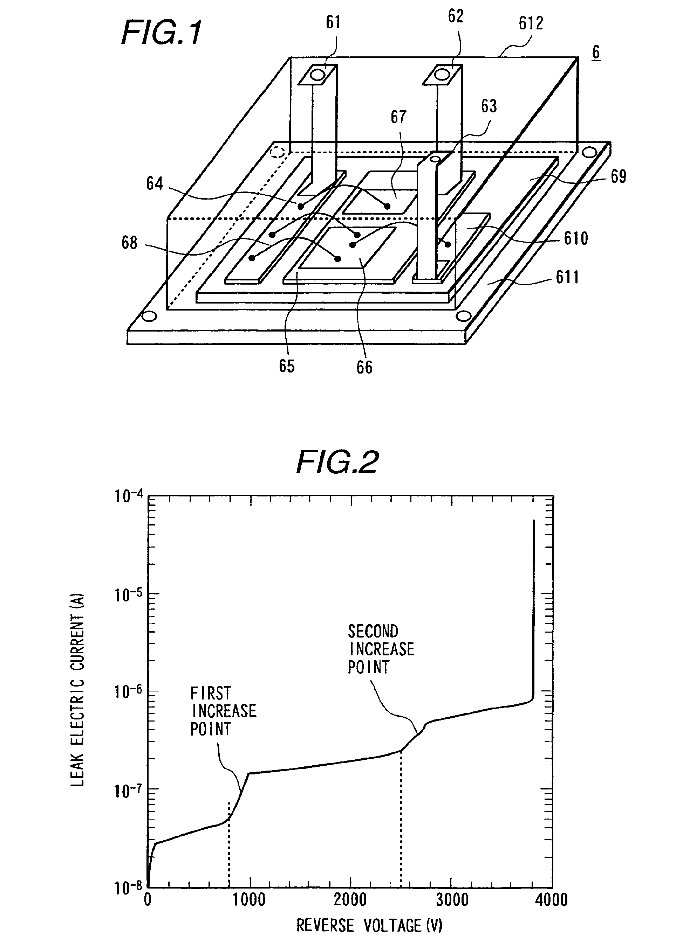

Fig. 1 illustrates an IGBT module 6 of an embodiment according to the present invention. An insulating plate 69 is provided on a heat-sink board 611 made of a metal, and a metal board 65 is provided on the insulating plate 69 . An IGBT66 and a diode 67 are arranged on the metal board 65. A collector electrode of the IGBT 66 and a cathode electrode of the diode 67 are connected to a collector terminal 62 together through the metal board 65. An emitter electrode of the IGBT 66 and an anode electrode of the diode 67 are connected to an emitter terminal 61 together through an emitter electrode board 64 by wiring 68, and a gate electrode of the IGBT 66 is connected to a gate terminal 63 through a gate electrode board 610. Therefore, the IGBT 66 and the diode 67 are connected in inverse parallel. The above mentioned structure is put in a plastic package 612, and each of the terminals 61, 62, 63 is exposed out from the plastic package 612.

Fig. 2 shows a leak electric current flowing between the emitter terminal 61 and the collector terminal 62 of the IGBT module 6 in Fig. 1. The leak current can be measured by applying a direct current voltage between the collector and emitter terminals 62, 61 with the IGBT 66 and the diode 67 off. The leak current indicates a first rapid increase on a low voltage side and a second rapid increase on a high-voltage side. At a first voltage value in the first rapid increase, a rate of the leak electric current increases sharply than the rate at a voltage lower than the first increase. At a second voltage value in the second increase, the rate of the leak electric current increases sharply than the rate at a voltage between the first and second increase. In Fig. 2, which is of a module having the rated blocking voltage of 3300V, the first voltage of the start of the first rapid increase is about 800 V and the second voltage of the start of the second rapid increase is about 2500 V. The leak current suddenly increases near 3800 V by avalanche.

Fig. 3 illustrates a cross section structure and a connection form of the IGBT 66 and the diode 67 in Fig.1. Impurity density of $p^+$ , p and $p^-$ semiconductor conductivity types become lower in this order, and $n^+$, n and n-conductivity types become lower similarly. In the IGBT 66, on a $p^+$ silicon substrate 27, a n layer 26 having impurity density lower than the substrate is formed, and a $n^-$ layer 29 having impurity density lower than the n layer is formed on the n layer. A $p^+$ layer 25 having impurity density higher than the m layer 29 is formed selectively to a surface part of the $n^-$ layer 29, and the $n^+$ layer 24 having impurity density higher than this $p^+$ layer 25 is formed selectively to a surface part in this $p^+$ layer 25. On a channel region in a surface part of the $p^+$ layer 25, between the $n^-$ layer 29 and the $n^+$ layer 24, a gate insulation film 22 is arranged, and a gate electrode 21 is arranged on the gate insulation film 22. An emitter electrode 23 electrically connecting to both of the $p^+$ layer 25 and the $n^+$ layer 24 is formed. A collector electrode 28 is provided on the $p^+$ silicon substarte 27. A local lifetime control region 210 ajacent to the n layer 26 and the $n^-$ layer 29 is formed. The local life time control region 210 is formed to a region extending over both of the n layer 26 and the $n^-$ layer 29 containing a neighborhood of a boundary between the n layer 26 and the $n^-$ 29.

In the diode 67, on a $n^+$ substrate 44, a $n^-$ layer 47 having impurity lower than this substrare is formed, and a $p^+$ layer 42 having impurity higher than the $n^-$ layer is formed on a surface part of the $n^-$ layer 47. A cathode electrode 46 electrically connected to the $n^+$ substrate 44 and an anode electrode 41 electrically connected to the $p^+$ layer 42 are provided. A local life time control region 45 is formed on the side of an area that is nearer to a cathode electrode 46 than a central part of the $n^-$ layer 47.

The collector electrode 28 of the IGBT 66 and the cathode electrode 46 of the diode 67 are electrically connected, and the emitter electrode 23 of the IGBT 66 and the anode electrode 41 of the diode 67 are electrically connected. The IGBT and the diode are electrically connected in reverse parallel. A local life time control in the IGBT is done by helium irradiating from the collector side, and a local life time control of the diode is done by proton irradiating from the anode side.

As follows, a result of the inventor's studying is described.

It is discovery that power loss becomes very small in the module that shows the leak electric current characteristics shown in Fig. 2 in result of measuring switching characteristics in the module that comprises the IGBT and diode that local life time controled is applied to. It is also discovery that the power loss reduces more when the voltage is set between the first reverse voltage on the side of a low voltage that a leak current increases and the second reverse voltage on the high voltage side from the first reverse voltage that a leak current increases. For clarifying the cause, in result of detail analyzing of the structures of the IGBT 66 and the diode 67 in the module that shows the leak current characteristics of Fig. 2 , the following are clarified. A module used for measurement has the rated blocking voltage of 3300V, in which the thickness of the $n^-$ layers 29, 47 of the IGBT 66 and the diode 67 are 350 $\mu$m and 400 $\mu$m, respectively, and the resistivity of the $n^-$ layer 29, 47 of the IGBT 66 and the diode 67 are 400 $\Omega \cdot$cm and 200 $\Omega \cdot$cm, respectively. The local life time control region 210 is provided in the IGBT 66 so that the region 210 is ajacent to the n layer 26 and the $n^-$ layer 29. The local life time control region 45 is provided on the side of cathode electrode 46 of the $n^-$ layer 47 in the diode. The local life time control region 210 of the IGBT 66 has an end portion at a distance of 370 $\mu$m from main junction J1, and the local life time control region 45 of the diode 67 has an end portion at a distance of 320 $\mu$m from main junction J41. Therefore, the start voltage of the first rapid increase depends on the local life time control region 210 in the IGBT 66, and the start voltage of the second rapid increase depends on the local life time control region 45 in the diode 67. Then, setting a voltage of a power source between these start voltages is the condition for reaching to the local life time control region 210 of a depletion layer in the IGBT 66 and for not reaching to the local life time control region 45 in the diode 67.

With swepting out accumulation carriers in the n⁻ layer 29 in a short time by an elecric field in the depletion layer, and with preventing re-injection of holes from the p⁺ layer 27, the turnoff loss of the IGBT 66 can be most effectively suppressed. The depletion layer in the IGBT 66 extends toward the side on the collector electrode 28 from main junction J1. At the same time, holes move to the p⁺ layer 25 and electrons move to the n layer 26. The depletion layer expands and fixes to the width that is decided by power voltage E1. Because the holes of carriers outside the depletion layer continue moving in the depletion layer, injecting positive holes from the p⁺ layer 27 contine to prevent electrons from becoming excessive. Therefore, the existence of the local life time control region 210 in the end portion of the depletion layer and a reduction of the carrier of the depletion layer end in the short time can suppress a re-injection of holes in the IGBT 66. In a punch-through type IGBT 66 having the n layer 26, the local life time control is applied to the position including a part of the n layer 26. Because the depletion layer does not expand further after it reaches the n layer 26, the carriers in the depletion layer end can be reduced in a short time without depending on voltage of a electric power source. Therefore, the position is most effective place for suppressing the re-injection of holes.

To prevent the noise generated by a sudden decrease of a recovery current, the depletion layer expanding from main junction J41 does not reach the n⁺ layer 44 in the diode 66. Therefore, a region that makes carriers remain is provided between the depletion layer and the n⁺ layer 44. However, power loss enlarges if the life time of this part is long. For preventing this, the life time of the region in which carriers remain is moderately shortened. The local life time control between the depletion layer and the n⁺ layer 44 in the diode are effective for reduction of power loss.

Consequently, the part to which the local life time control is applied is a region 210 including parts of the n⁻ layer 29 and n layer 26 in the IGBT 66, and is a region 45 outside of a depletion layer expanding from junction J41 between the of the n⁻ layer layer 47 and p⁺ 42 in the diode 67. If voltage more than the first rapid increase voltage that a leak current rate increases at is applied, turn-off loss can be reduced because the depletion layer end of the IGBT 66 reaches to the local life time control region 210. On the other hand, if a power voltage is lower than the second rapid increase voltage that the leak current rate increases at, recovery loss can be reduced because a local life time control region 45 is outside the depletion layer.

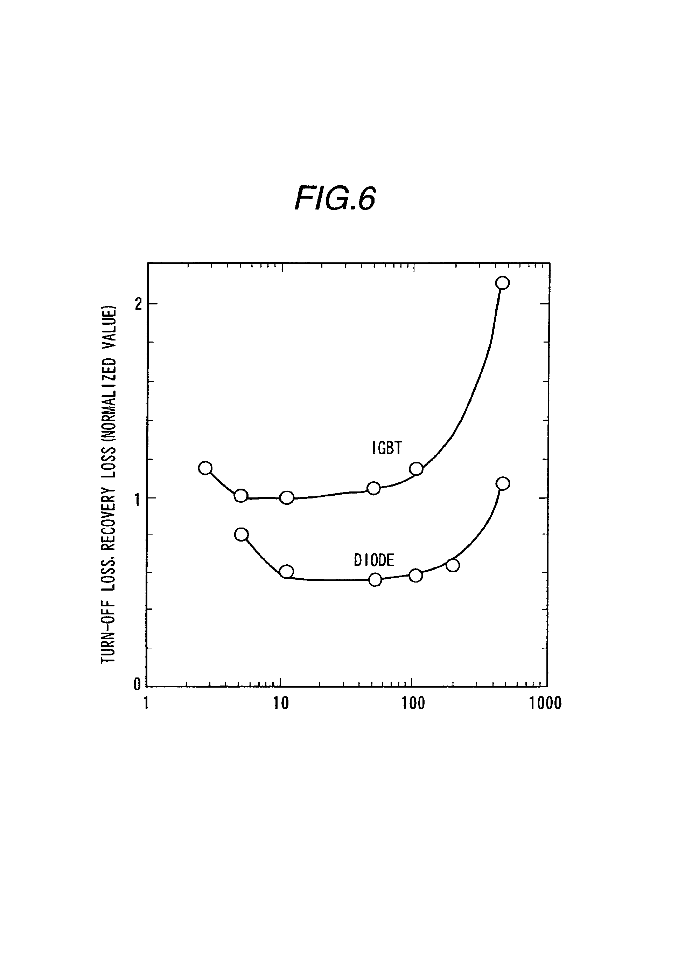

Fig.6 shows a dependence on the width of the local life time control region 210, 45 in turn-off loss of the IGBT 66 and recovery loss of the diode 67. The width of the local life time control region 210, 45 is shown with the half-value width of an injected ion kind distribution. The IGBT module of Fig. 1 has rated voltage of 3300V. The power source voltage for measurement is 1500 V. The value of loss is normalized by the mimum loss of the IGBT 66. The thickness of n⁻ layer 29 is 350 μm in the IGBT 66, and the thickness of n⁻ layer 47 that is 400 μm in the diode 67. When a half value width is smaller than 5 μm or more than 100 μm in the IGBT 66, loss increases. When the half-value width is smaller than 10 μm or more than 200 μm in the diode 67, loss increases. Therefore, the width of the local life time control region 210 of the IGBT 66 is made narrower than the width of the local life time control region 45 of the diode 67 for low loss of the IGBT module.

An ion kind is irradiated from the side of collector electrode 28 of the IGBT 66 and the side of the anode electrode 41 of a diode 67. Because the ion kind generates a defect at the position where it passes as well as the part where it stops, when the ion kind is irradiated from the side of emitter electrode 23 of the IGBT 66, the life time of the whole n⁻ layer 29 becomes short. When the life time of the n⁻ layer 29 becomes short, loss increases because on- voltage increases. On the other hand, if the ion kind is irradiated from the collector electrode 28 side, an increase of the on-voltage can be suppressed because the defect partially occurs in the n⁻ layer 29 near the n layer 26. It is desirable that the peak value of a recovery electric current should reduce for soft recovery characteristics in the diode 67. Because the peak value of the recovery current depends on the carrier density of the neighborhood of the n⁻ layer 47 and p⁺ 42, it is necessary that the peak value is reduced. Therefore, it is desirable that a carrier near J41 in the diode 67 is reduced by injecting the ion kind from the anode electrode 41 side.

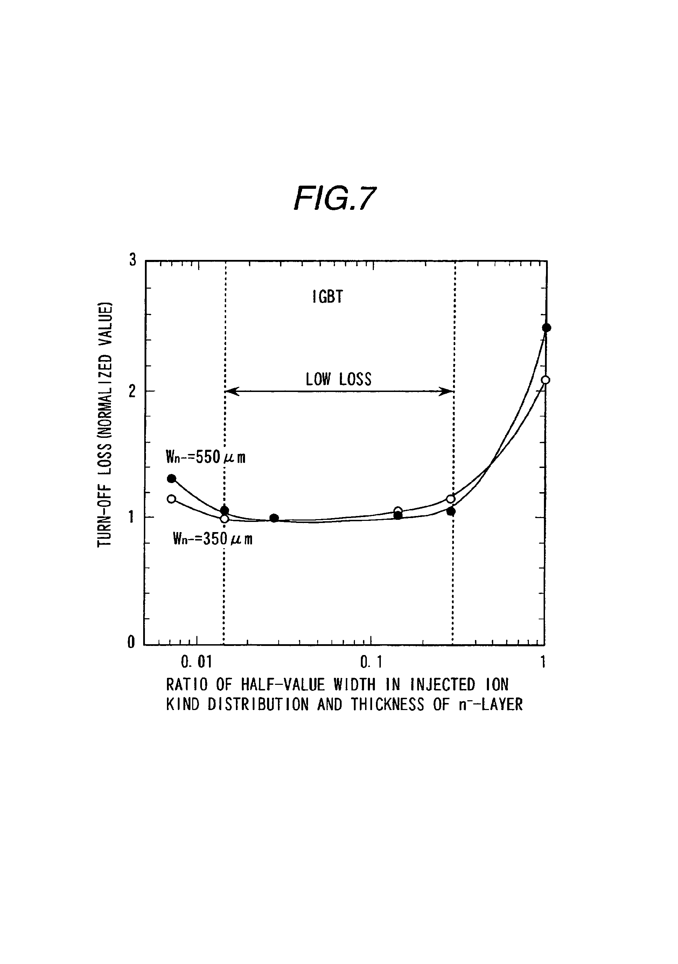

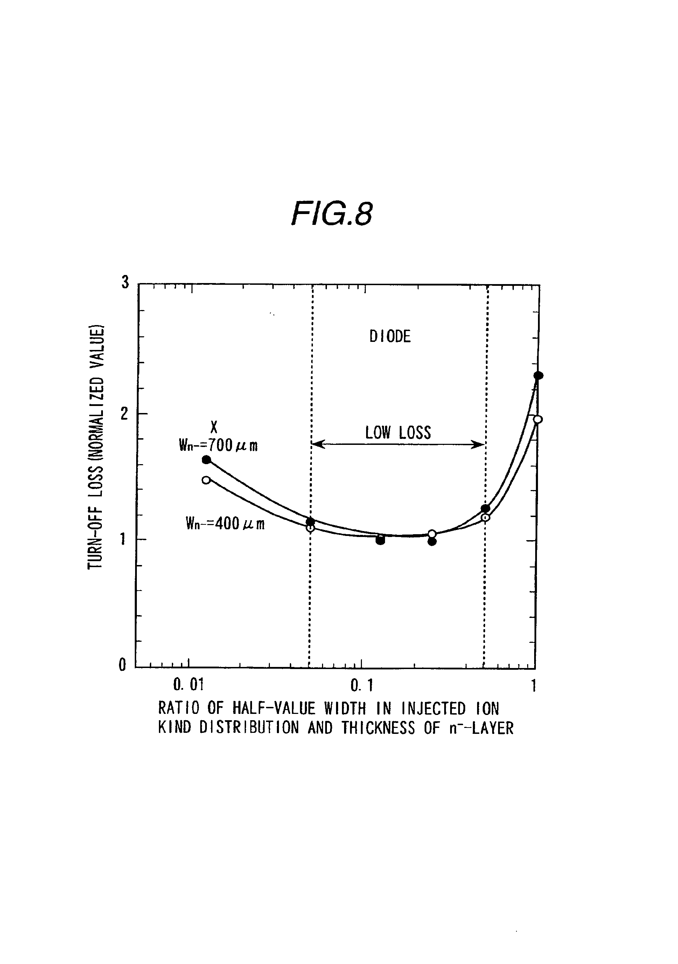

The relationships between a width and loss of distributions of the ion kind in each of the IGBT 66 and the diode 67 having different blocking voltage are compared. It is necessary that the width of the n⁻ layer 29 or 47 in a device 66, 67 having high blocking voltage should thicken. This is so that the blocking voltage is maintained in the n⁻ layer 29, 47. In Fig. 7, IGBTs having the blocking voltage of 3300 V and 5000V are compared, the half-value width of an injection ion kind is normalized by width Wn⁻ of the n⁻ layer 29. The width of the n⁻ layer 29 in 3300 V and 5000 V IGBTs are 350 μm and 550 μm respectively. The width of the n⁻ layer 29 is a width that is necessary to gain each blocking voltage. As a similar comparison about a diode is shown in Fig. 8 The width of the n⁻ layer 47 in 3300 V and 5000 V diodes are 450 μm and 700 μm respectively. The width of n⁻ layer is a width that is necessary for soft recovery characteristics with supplying enough residual carriers. The power source voltage used for measurement is 1500 V in 3300 V devices, and 3000 V in 5000 V devices. It is clear from these results that there is a relation to reduce loss between the half-value width λ of an injection ion kind distribution and the width Wn⁻ of n⁻ layer. In the range of $0.014 \leqq \lambda /Wn^- \leqq 0.3$ in the IGBT, and in the range of $0.05 \leqq \lambda/Wn^- \leqq 0.5$ in the diode, the loss is minimized without the dependence on the width of the n⁻ layer. From the result of Fig. 6, Fig. 7 and Fig. 8, it is newly found that making the width of the local life time control region in the IGBT narrower than that in the diode and the above range is suitable to increase a power electric current with reducing of the power loss of the IGBT module.

The width of the local life time control region in the IGBT is narrower than that in the diode. The driving by the power source voltage is so that the depletion layer in the IGBT reaches to the local life time control region and the depletion layer in the diode does not reach to the local life time control region. Therefore, it is desirable that electric power converter is comprised by use of the module having the first reverse voltage that the leak current increases and the second reverse voltage like the characteristics of Fig. 2, and that the converter is drived by a power voltage set between the first reverse voltage and the second reverse voltage.

Fig. 9 shows an example of the main circuit of the power inverter according to the present invention. The module of Fig. 1 is applied to a parallel circuit part enclosed in a dotted line in the Fig.9 where the IGBT 66 and the diode 67 are connected in inverse parallel. This inverter has a pair of direct current terminals T1 and T2, and 3 alternating current terminals T3, T4 and T5 of which the number is equal to the number of phases of an alternating current. A direct current power source is connected to the direct current terminals. The direct current electric power is converted into alternating current electric power by switching the IGBTs 66 in the IGBT modules M11 - M32. And then, the alternating current electric power is output to alternating current terminals. Each of both terminals in respectively series connected 2 modules M11 and M12, M21 and M22, M31 and M32 are connected to the direct current terminals. The alternating current terminals are pulled out from the series node of 2 modules.

The inverse parallel circuit of the IGBT 66 and the diode 67 surrounded in a dotted line in this figure is comprised by the IGBT module shown in Fig. 1. Therefore, the electric current coefficient of utilization of the inverter is improved and the inverter is miniaturized because the loss of the IGBT 66 and the diode 67 is reduced. Additionally, the conversion efficiency also greatly improves because the loss of a module reduces.

The invention is applied another device or apparatus such as a parallel circuit of an IGBT and a diode, and an semiconductor device in which an IGBT and diode are integrated.

As mentioned above, according to the present invention, the loss of the IGBT module can be reduced. As a result, miniaturization of the power inverter is enabled.

## Claims

1. A semiconductor device (6) comprising:

    a parallel circuit having an insulated gate bipolar transistor (66) and a diode (67) connected in inverse parallel;
    the insulated gate bipolar transistor (66) comprising:

        a first semiconductor region (27) of a first conductivity type;
        a second semiconductor region (26, 29) of a second conductivity type adjacent to the first semiconductor region (27);
        a third semiconductor region (25) of the first conductivity type adjacent to the second semiconductor region (26, 29);
        a fourth semiconductor region (24) of the second conductivity type, said fourth semiconductor region provided in the third semiconductor region (25);
        a first main electrode (28) that contacts the first semiconductor region (27) low resistively (ohmically);
        a second main electrode (23) that low resistively contacts the third and fourth semiconductor region (25, 24), and
        an insulated gate that is provided through an insulation film (22) on a surface of the third semiconductor region (25);
        the diode (67) comprising:

            a fifth semiconductor region (44, 47) of the second conductivity type;
            a sixth semiconductor region (42) of the first conductivity type adjacent to the fifth semiconductor region (44, 47);
            a third main electrode (46) that contacts the fifth semiconductor region (44, 47) low resistively;
            a fourth main electrode (41) that contacts the sixth semiconductor region (42) low resistively;

    wherein the first main electrode (28) and the third main electrode (46) are electrically connected and the second main electrode (23) and the fourth main electrode (41) are electrically connected, and
    **characterised in that**:

        the second semiconductor region (26, 29) has a first local life time control region (210) and the fifth semiconductor region (44, 47) has a second local life time control region (45) that are arranged such that the semiconductor device exhibits a sharp increase in leak current rate at a first voltage value and a second voltage value if a blocking voltage is applied to said parallel circuit, said second voltage value being larger than said first voltage value.

2. A semiconductor device according to claim 1, wherein a depletion layer in the insulated gate bipolar transistor (66) reaches the first local life time control region (210) at the first voltage value, and a depletion layer in the diode (67) reaches the second local life time control region (45) at the second voltage value.

3. A semiconductor device according to claim 1, wherein a width of the first local life time control region (210) is narrower than a width of the second local life time control region (45).

4. A semiconductor device according to claim 3, wherein the second semiconductor region includes a low impurity concentrated base layer (29) having a thickness $Wn_1^-$, the fifth semiconductor region includes a low impurity concentrated base layer (47) having a thickness $Wn_2^-$, and irradiation distributions for the first and second local life time control regions (210, 45) have first and second half value widths $\lambda_1$ and $\lambda_2$ respectively, where

$$0.0145 \leq \frac{\lambda_1}{Wn_1^-} \leq 0.3,$$

and

$$0.05 \leq \frac{\lambda_2}{Wn_2^-} \leq 0.5$$

5. A semiconductor device according to claim 1, wherein the first local life time control region (210) includes an influx of an ion kind from a collector side of the insulated gate bipolar transistor (66) and the second local life time control region (45) includes an influx of an ion kind from an anode side of the diode (67).

6. A semiconductor device according to claim 5, wherein the ion kind in the insulated gate bipolar transistor (66) is helium and the ion kind in the diode (67) is a proton.

7. A semiconductor device according to claim 1, wherein the second semiconductor region has a first part (26) adjacent to the first semiconductor region (27) and a second part (29) of impurity density lower than the first part (26) adjacent to the first part (26) and the third semiconductor region (25), and the local life time control region (210) in the second semiconductor region is provided in a region that extends over the first part (26) and the second part (29) containing the boundary between the first part (26) and the second part (29), and

the fifth semiconductor region has a third part (44) that contacts the third main electrode (46) and a fourth part (47) adjacent to the third part (44) and the sixth semiconductor region (42), said fourth part (47) having an impurity density that is lower than the third part (44) and the local life time control region (45) in the fifth semiconductor region is provided in the fourth part (47).

8. A method of driving a semiconductor device according to any preceding claim, the method comprising supplying a direct current voltage to the semiconductor device, wherein the direct current voltage is set between the first voltage value and the second voltage value.

9. An electric power converter comprising a semiconductor device according to any of claims 1 to 7, the converter being arranged to convert electric power by switching a direct current voltage supplied to the semiconductor device on and off, wherein the direct current voltage is set between the first voltage value and the second voltage value.

**Patentansprüche**

1. Halbleitervorrichtung (6) mit

einem Parallelkreis, in dem ein Bipolartransistor (66) mit isoliertem Gate und eine Diode (67) antiparallel geschaltet sind,
wobei der Bipolartransistor (66) aufweist:

einen ersten Halbleiterbereich (27) eines ersten Leitungstyps,
einen diesem benachbarten zweiten Halbleiterbereich (26, 29) eines zweiten Leitungstyps,
einen dem zweiten Halbleiterbereich (26, 29) benachbarten dritten Halbleiterbereich (25) des ersten Leitungstyps,
einen in dem dritten Halbleiterbereich (25) vorgesehenen vierten Halbleiterbereich (24) des zweiten Leitungstyps,
eine den ersten Halbleiterbereich (27) niederohmig kontaktierende erste Hauptelektrode (28),
eine den dritten und den vierten Halbleiterbereich (25, 24) niederohmig kontaktierende zweite Hauptelektrode (23) und

ein über einen Isolierfilm (22) auf einer Oberfläche des dritten Halbleiterbereichs (25) vorgesehenes isoliertes Gate, und wobei die Diode (67) aufweist:

einen fünften Halbleiterbereich (44, 47) des zweiten Leitungstyps, einen diesem benachbarten sechsten Halbleiterbereich (42) des ersten Leitungstyps, eine den fünften Halbleiterbereich (44, 47) niederohmig kontaktierende dritte Hauptelektrode (46), und eine den sechsten Halbleiterbereich (42) niederohmig kontaktierende vierte Hauptelektrode (41),

wobei die erste und die dritte Hauptelektrode (28, 46) elektrisch miteinander verbunden und die zweite und die vierte Hauptelektrode (23, 41) elektrisch miteinander verbunden sind, **dadurch gekennzeichnet, dass** der zweite Halbleiterbereich (26, 29) einen ersten lokalen Lebensdauer-Steuerbereich (210) und der fünfte Halbleiterbereich (44, 47) einen zweiten lokalen Lebensdauer-Steuerbereich (45) aufweist, wobei die Steuerbereiche so ausgelegt sind, dass die Halbleitervorrichtung bei Anlegen einer Sperrspannung an den Parallelkreis bei einem ersten und einem zweiten Spannungswert einen scharfen Leckstromanstieg aufweist, wobei der zweite Spannungswert höher ist als der erste.

2. Halbleitervorrichtung nach Anspruch 1, wobei bei dem ersten Spannungswert eine Verarmungsschicht in dem Bipolartransistor (66) den ersten lokalen Lebensdauer-Steuerbereich (210) und bei dem zweiten Spannungswert eine Verarmungsschicht in der Diode (67) den zweiten lokalen Lebensdauer-Steuerbereich (45) erreicht.

3. Halbleitervorrichtung nach Anspruch 1, wobei die Breite des ersten lokalen Lebensdauer-Steuerbereichs (210) geringer ist als die des zweiten lokalen Lebensdauer-Steuerbereichs (45).

4. Halbleitervorrichtung nach Anspruch 3, wobei der zweite Halbleiterbereich eine Grundschicht (29) mit geringer Störstoffkonzentration und einer Dicke $Wn_1^-$, der fünfte Halbleiterbereich eine Grundschicht (47) mit geringer Störstoffkonzentration und einer Dicke $Wn_2^-$ aufweist, und wobei die Strahlungsverteilungen für den ersten und den zweiten lokalen Lebensdauer-Steuerbereich (210, 45) eine erste bzw. eine zweite Halbwertsbreite $\lambda_1$ und $\lambda_2$ aufweisen, wobei

$$0,0145 \le \frac{\lambda_1}{Wn_1^-} \le 0,3,$$

und

$$0,05 \le \frac{\lambda_2}{Wn_2^-} \le 0,5.$$

5. Halbleitervorrichtung nach Anspruch 1, wobei der erste lokale Lebensdauer-Steuerbereich (210) einen Zustrom einer Ionenart von der Kollektorseite des Bipolartransistors (66) und der zweite lokale Lebensdauer-Steuerbereich (45) einen Zustrom einer Ionenart von der Anodenseite der Diode (67) aufweist.

6. Halbleitervorrichtung nach Anspruch 5, wobei die Ionenart in dem Bipolartransistor (66) Helium und die Ionenart in der Diode (67) ein Proton ist.

7. Halbleitervorrichtung nach Anspruch 1, wobei der zweite Halbleiterbereich einen dem ersten Halbleiterbereich (27) benachbarten ersten Teil (26) und einen diesem und dem dritten Halbleiterbereich (25) benachbarten zweiten Teil (29) mit geringerer Störstoffkonzentration als der erste Teil (26) aufweist, und der erste lokale Lebensdauer-Steuerbereich (210) in dem zweiten Halbleiterbereich in einem Bereich vorgesehen ist, der über dem ersten und dem zweiten Teil (26, 29) liegt und die Grenze zwischen diesen enthält, und der fünfte Halbleiterbereich einen die dritte Hauptelektrode (46) kontaktierenden dritten Teil (44) und einen diesem und dem sechsten Halbleiterbereich (42) benachbarten vierten Teil (47) mit geringerer Störstoffdichte als der dritte Teil (44) aufweist und der lokale Lebensdauer-Steuerbereich (45) in dem fünften Halbleiterbereich in dem vierten Teil (47) vorgesehen ist.

8. Verfahren zum Ansteuern einer Halbleitervorrichtung nach einem der vorhergehenden Ansprüche, wobei an diese eine Gleichspannung angelegt wird, die zwischen dem ersten und dem zweiten Spannungswert liegt.

9. Stromrichter mit einer Halbleitervorrichtung nach einem der Ansprüche 1 bis 7 zum Umrichten elektrischer Leistung durch Ein- und Ausschalten einer an die Halbleitervorrichtung angelegten Gleichspannung, die zwischen dem ersten und dem zweiten Spannungswert liegt.

**Revendications**

1. Dispositif à semi-conducteurs (6) comportant :

un circuit parallèle ayant un transistor bipolaire à grille isolée (66) et une diode (67) montés en parallèle inverse,
le transistor bipolaire à grille isolée (66) comportant :

une première région semi-conductrice (27) d'un premier type de conductivité,
une deuxième région semi-conductrice (26, 29) d'un second type de conductivité adjacente à la première région semi-conductrice (27),
une troisième région semi-conductrice (25) du premier type de conductivité adjacente à la deuxième région semi-conductrice (26, 29),
une quatrième région semi-conductrice (24) du second type de conductivité, ladite quatrième région semi-conductrice étant agencée dans la troisième région semi-conductrice (25),
une première électrode principale (28) qui est en contact avec la première région semi-conductrice (27) à faible résistance (de manière ohmique),
une deuxième électrode principale (23) qui est en contact à faible résistance avec les troisième et quatrième régions semi-conductrices (25, 24), et
une grille isolée qui est agencée à travers un film isolant (22) sur une surface de la troisième région semi-conductrice (25),
la diode (67) comportant :

une cinquième région semi-conductrice (44, 47) du second type de conductivité,
une sixième région semi-conductrice (42) du premier type de conductivité adjacente à la première région semi-conductrice (44, 47),
une troisième électrode principale (46) qui est en contact avec la cinquième région semi-conductrice (44, 47) à faible résistance,
une quatrième électrode principale (41) qui est en contact avec la sixième région semi-conductrice (42) à faible résistance,
la première électrode principale (28) et la troisième électrode principale (46) étant électriquement connectées et la deuxième électrode principale (23) et la quatrième électrode principale (41) étant électriquement connectées, et

**caractérisé en ce que** ;
la deuxième région semi-conductrice (26, 29) a une première région de commande de durée de vie locale (210) et la cinquième région semi-conductrice (44, 47) a une seconde région de commande de durée de vie locale (45) qui sont agencées de sorte que le dispositif à semi-conducteurs présente une brusque augmentation de la vitesse de courant de fuite à une première valeur de tension et à une seconde valeur de tension si une tension de blocage est appliquée audit circuit parallèle, ladite seconde valeur de tension étant plus grande que ladite première valeur de tension.

2. Dispositif à semi-conducteurs selon la revendication 1, dans lequel une couche d'appauvrissement dans le transistor bipolaire à grille isolée (66) atteint la première région de commande de durée de vie locale (210) à la première valeur de tension, et une couche d'appauvrissement dans la diode (67) atteint la seconde région de commande de durée de vie locale (45) à la seconde valeur de tension.

3. Dispositif à semi-conducteurs selon la revendication 1, dans lequel une largeur de la première région de commande de durée de vie locale (210) est plus étroite qu'une largeur de la seconde région de commande de durée de vie locale (45).

4. Dispositif à semi-conducteurs selon la revendication 3, dans lequel la deuxième région semi-conductrice inclut une couche de base à faible concentration d'impuretés (29) ayant une épaisseur $Wn_1^-$, la cinquième région semi-conductrice inclut une couche de base à faible concentration d'impuretés (47) ayant une épaisseur $Wn_2^-$, et des distributions d'irradiation pour les première et seconde régions de commande de durée de vie locale (210, 45) ont des première et seconde largeurs de demi-valeur $\lambda_1$ et $\lambda_2$ respectivement où

$$0{,}0145 \le \frac{\lambda_1}{Wn_1^-} \le 0{,}3,$$

et

$$0{,}05 \le \frac{\lambda_2}{Wn_2^-} \le 0{,}5$$

5. Dispositif à semi-conducteurs selon la revendication 1, dans lequel la première région de commande de durée de vie locale (210) inclut un débit entrant d'un type d'ion provenant d'un côté de collecteur du transistor bipolaire à grille isolée (66) et la seconde région de commande de durée de vie locale (45) inclut un débit entrant d'un type d'ion provenant d'un côté d'anode de la diode (67).

6. Dispositif à semi-conducteurs selon la revendication 5, dans lequel le type d'ion dans le transistor bipolaire à grille isolée (66) est de l'hélium et le type d'ion dans la diode (67) est un proton.

7. Dispositif à semi-conducteurs selon la revendication 1, dans lequel
la deuxième région semi-conductrice a une première partie (26) adjacente à la première région semi-conductrice (27) et une deuxième partie (29) de densité d'impureté inférieure à la première partie (26) adjacente à la première partie (26) et à la troisième région semi-conductrice (25), et la région de commande de durée de vie locale (210) dans la deuxième région semi-conductrice est agencée dans une région qui s'étend sur la première partie (26) et la deuxième partie (29) contenant la limite entre la première partie (26) et la deuxième partie (29), et
la cinquième région semi-conductrice a une troisième partie (44) qui est en contact avec la troisième électrode principale (46) et une quatrième partie (47) adjacente à la troisième partie (44) et à la sixième région semi-conductrice (42), ladite quatrième partie (47) ayant une densité d'impureté qui est inférieure à la troisième partie (44) et la région de commande de durée de vie locale (45) de la cinquième région semi-conductrice est agencée dans la quatrième partie (47).

8. Procédé pour attaquer un dispositif à semi-conducteurs selon l'une quelconque des revendications précédentes, le procédé comportant l'étape consistant à délivrer une tension à courant continu au dispositif à semi-conducteurs, la tension à courant continu étant établie entre la première valeur de tension et la seconde valeur de tension.

9. Convertisseur de puissance électrique comportant un dispositif à semi-conducteurs selon l'une quelconque des revendications 1 à 7, le convertisseur étant conçu pour convertir une puissance électrique en bloquant ou en laissant passer une tension à courant continu délivrée au dispositif à semi-conducteurs, la tension à courant continu étant établie entre la première valeur de tension et la seconde valeur de tension.

*FIG.1*

*FIG.2*

**FIG.3**

**FIG.4**

FIG.5

$V_G$ (UPPER ARM)

$V_A$ (UPPER ARM)

$V_{AK}$ (UPPER ARM)

RECOVERY CURRENT

$V_{CE}$ (LOWER ARM)

$I_C$ (LOWER ARM)

TAIL CURRENT

RECOVERY LOSS

TURN-OFF LOSS

POWER LOSS

t1        t2        t3        t4

FIG.9

$T_1$    $M_{11}$        $M_{21}$        $M_{31}$

$+$

$T_3$  $T_4$

$T_5$

$-$

$T_2$    $M_{12}$        $M_{22}$        $M_{32}$

13

# FIG.6

## FIG.7

## FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9121052 A
- JP 55038058 A
- EP 0423721 A